# EUROPEAN PATENT APPLICATION

(11) **EP 1 863 043 A2**
(43) Date of publication of application: **05.12.2007**
(21) Application number: 07009030.3
(22) Date of filing: 04.05.2007
(51) Int. Cl.: H01F 17/06, H01F 27/06

(54) **Mounting structure of ferrite core**

(30) Priority: 30.05.2006 JP 2006149224
(71) Applicant: ORION ELECTRIC CO., Ltd., Fukui 915-8555 (JP)
(72) Inventor: Oda, Takato, Echizen-shi Fukui 915-8555 (JP)
(74) Representative: Vossius & Partner

(57) **Abstract**

To mount a ferrite core (9) stably without damaging a cable (13), a mounting structure of the ferrite core (9) includes an outer-circumferential-side holding member (4, 17) for supporting an outer circumferential face (11) of the ferrite core (9), and an inner-circumferential-side holding member (5, 18) for supporting an inner circumferential face (12). At least one of the outer-circumferential-side holding member (4, 17) and the inner-circumferential-side holding member (5, 18) is formed to extend in an axial direction of the ferrite core so that it can deflect by elastic deformation, thereby the outer-circumferential-side holding member and the inner-circumferential-side holding member nip the ferrite core while applying elastic force thereto.

## Description

The present invention relates to a mounting structure of a ferrite core for removing noise flowing through a cable.

Radiation noise is generated from an external input device such as a handy scanner for image input, or a mouse for data processing on a screen. Therefore, a measure for removing noise is used for the external input device to prevent effects of the radiation noise on office automation equipment via a cable. Typically, a ferrite core is equipped in a portion of a cable within an input device body, the portion being led from the input device body, and an output signal from the input device body passes through the ferrite core, and thereby the radiation noise is removed.

That is, a ring-like ferrite core is mounted in a device, and a cable is wound on or inserted into the ferrite core, thereby noise can be removed. As a result, a noiseless signal can be outputted. Various structures are known for mounting such a ferrite core. For example, in "External Input Device" according to JP-UM-A-05-4661, a ferrite core fixing rib is provided on an upper case of the input device body, in addition, a ferrite core fixing rib is provided on a lower case, consequently a ferrite core equipped in a signal line is held by the respective ferrite core fixing ribs.

However, in such a structure, since the ferrite core is held by the ferrite core fixing rib on the upper case, when the cable is wound on the ferrite core, the upper case needs to be capped on the lower case taking care for the cable not to be nipped between the ferrite core fixing rib on the upper case and the ferrite core. Even if the cable is nipped between them by mistake, when the upper case is capped on the lower case, the cable is left while the fact of such nipping is unknown, consequently the cable may be damaged.

"Mounting Structure of Ferrite Core" according to JP-UM-A-06-3649 provides a mounting structure of ferrite core that is easy in assembling and improved positioning accuracy, wherein a ferrite core inserted with a lead wire is set into a case having a semicircular groove and a hook, then the ferrite core is retained by a ferrite core retainer and then locked by a hook, so that the ferrite core is fixed to a determined mounting position. However, since the ferrite core is structured to be retained by the ferrite core retainer, when a cable is wound on the ferrite core, the cable may be nipped between the ferrite core retainer and the ferrite core, therefore the cable is possibly damaged.

Furthermore, "Fixing Tool, and Liquid Injection Device Using the Fixing Tool" according to JP-A-2006-13060 includes a fixing tool for securely fixing a wiring line inserted into a ferrite core to a device body with a small number of parts; wherein a ferrite core saddle includes a plate like saddle body, an latch section being disposed on one surface of the saddle body and latched with a main frame, and a pair of wiring grasping section being disposed in pair on the other surface of the saddle body with being separated from each other by a distance approximately equal to length of the ferrite core in a longitudinal direction of the wiring line and grasping the wiring line at both sides of the ferrite core in the longitudinal direction of the wiring line respectively

However, while the wiring line is grasped by the pair of wiring grasping section of the ferrite core saddle, the fixing tool is not structured such that the ferrite core is directly fixed. Therefore, when vibration or shock is applied, the ferrite core may be moved to a position displaced from a position on the ferrite core saddle, and the wiring line may be tensioned at that time, consequently the wiring line may be damaged, or may fall off from the wiring grasping section.

An embodiment of the invention was made to solve such a difficulty in the prior art, and is intended to provide a mounting structure in which even if a cable is inserted into a hole of a ferrite core, or even if a cable is wound on a ferrite core, the ferrite core can be stably mounted without damaging the cable.

Thus, a mounting structure of a ferrite core according to the invention includes an outer-circumferential-side holding member for supporting an outer circumferential face of a ring-like ferrite core, and an inner-circumferential-side holding member for supporting an inner circumferential face, wherein at least one of the outer-circumferential-side holding member and the inner-circumferential-side holding member is formed to extend in an axial direction of the ferrite core so that it can deflect by elastic deformation, thereby the outer-circumferential-side holding member and the inner-circumferential-side holding member nip the ferrite core while applying elastic force thereto. That is, the inner-circumferential-side holding member is inserted into the ferrite core, and nips the ferrite core while applying the elastic force with the outer-circumferential-side holding member contacting to an outer circumferential face of the core.

At least one of the outer-circumferential-side holding member and the inner-circumferential-side holding member is flexibly formed by using synthetic resin or the like.

Preferably, it is configured that the outer-circumferential-side holding member includes a pair of members disposed parallel to each other with a predetermined interval, and the inner-circumferential-side holding member is disposed in the middle of the two outer-circumferential-side holding members. According to such a configuration, the ferrite core is nipped in a manner that two points on the outer circumference of the ferrite core are supported by the two outer-circumferential-side holding members respectively, and a point at the inner circumferential side is pressed by the inner-circumferential-side holding member.

A projection to be latched on an end face of the ferrite core is preferably formed on a tip of at least one of the outer-circumferential-side holding member and the inner-circumferential-side holding member. According to such a configuration, falling off of the ferrite core being mounted and supported is prevented.

The outer-circumferential-side holding member and the inner-circumferential-side holding member may be formed integrally with a baseboard of a device body on which an electronic component such as a printed circuit board is to be mounted. Alternatively, it is acceptable that a base for integrally connecting the outer-circumferential-side holding member to the inner-circumferential-side holding member is formed, and the base has a leg to be freely removable or mountable with respect to the base board of the device body.

An embodiment of the invention is structured such that the ring-like ferrite core is nipped by the outer-circumferential-side holding member situated in the outer circumferential side of the ferrite core and the inner-circumferential-side holding member situated in the inner circumferential side. That is, in the mounting structure, the ring-like ferrite core is pressed by the inner-circumferential-side holding member while the ferrite core is set on the outer-circumferential-side holding member. Therefore, since most of the ferrite core is not restrained except for a part at a lower side, the mounting structure can be available for either of a case that a cable is inserted through a hole of the ferrite core, and a case that the cable is wound on the ferrite core. In this case, damage of the cable is not caused by being nipped by the outer-circumferential-side holding member and the inner-circumferential-side holding member.

Since the ferrite core is nipped while being applied with elastic force by the outer-circumferential-side holding member and the inner-circumferential-side holding member, the ferrite core can be stably mounted. Moreover, a projection is formed at a tip of the outer-circumferential-side holding member or the inner-circumferential-side holding member, thereby the ferrite core can be prevented from falling off from the outer-circumferential-side holding member and the inner-circumferential-side holding member. When the ferrite core is mounted, at least one of the outer-circumferential-side holding member and the inner-circumferential-side holding member is deformed in a deflective manner, thereby the ferrite core can be easily nipped and mounted.
Figs. 1A and 1B are a plane view and a front view respectively, showing a base board having a core mounting section according to an embodiment of the invention;
Figs. 2A, 2B and 2C are a perspective view, a plane view, and a front view respectively, showing the core mounting section in an enlarged manner,
Figs. 3A, 3B and 3C are a plane view, a front view, and a section view along a line X-X of Fig. 3A respectively, showing the base board in which a ferrite core is mounted on the core mounting section, and various electronic components are mounted on the base board;
Figs. 4A and 4B are a front view and a side view, showing the ferrite core;
Figs. 5A and 5B are a plane view and a front view, showing a condition that the core mounting section is mounted with the ferrite core;
Fig. 6 is an enlarged section view along a line Y-Y of Fig. 5A; and
Figs. 7A, 7B and 7C are a plane view, a front view, and a side view respectively, showing a core mounting section according to another embodiment.

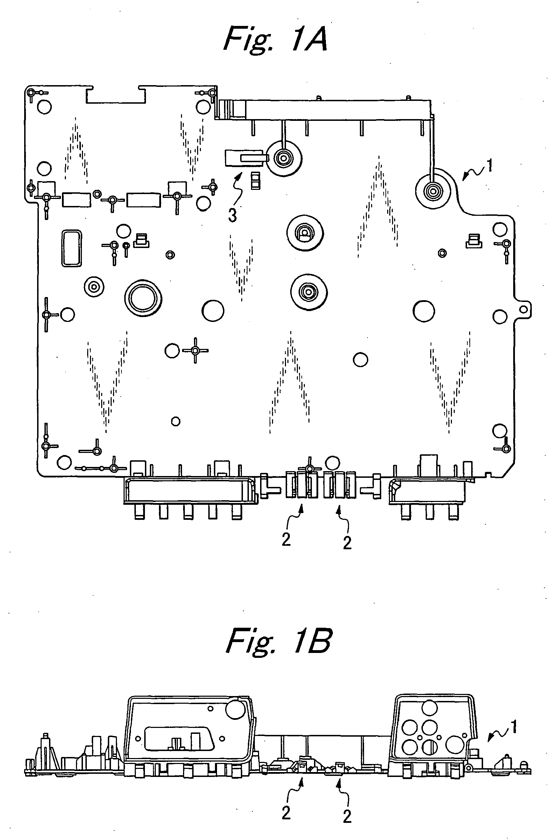

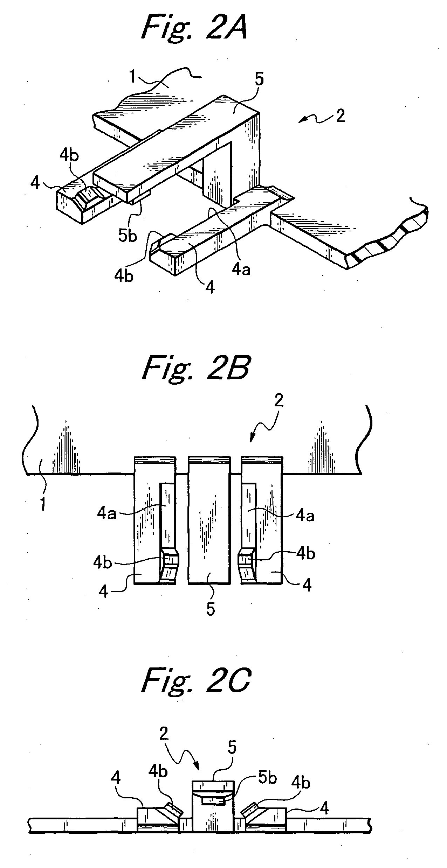

Figs. 1 A and 1 B show a baseboard 1 for configuring an electronic device, and the baseboard 1 is mounted with various electronic components such as a printed circuit board. The baseboard 1 is made of resin, and has core mounting sections 2, 2 and 3 for mounting ferrite cores. Figs. 2A, 2B and 2C show the relevant core mounting section 2 in an enlarged manner.

The core mounting section 2 has two outer-circumferential-side holding members 4, 4 and one inner-circumferential-side holding member 5, and the outer-circumferential-side holding members 4, 4 and the inner-circumferential-side holding member 5 horizontally extend from a side edge of the base board 1 so that they can be deformed in a deflective manner. That is, the outer-circumferential-side holding members 4, 4 and the inner-circumferential-side holding member 5 are made of resin and integrally molded with the base board 1, and can be deflected by elastic deformation. The two outer-circumferential-side holding members 4, 4 extend parallel to each other with a predetermined interval in a horizontal direction. The inner-circumferential-side holding member 5 is provided in an intermediate position between the outer-circumferential-side holding members 4 and 4, and extends parallel to the outer-circumferential-side holding members 4, 4 in a horizontal direction.

Projections 4b, 4b are provided protrusively to an obliquely inner upside at tips of the outer-circumferential-side holding members 4, 4, and a projection 5a is provided protrusively to a downside at a tip of the inner-circumferential-side holding member 5. Slopes 4a, 4a being inwardly inclined are formed in the outer-circumferential-side holding members 4, 4, and the projections 4b, 4b are protrusively provided on the slopes 4a, 4a.

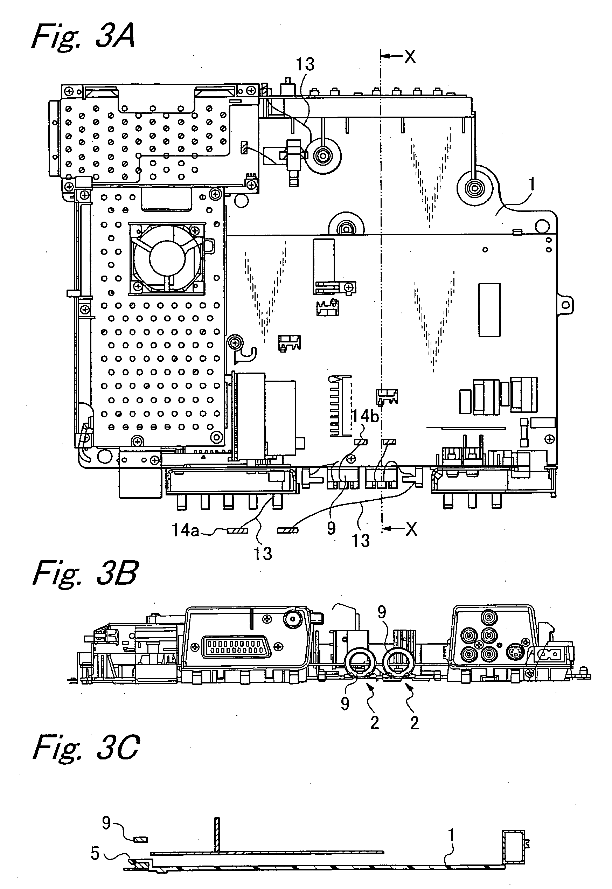

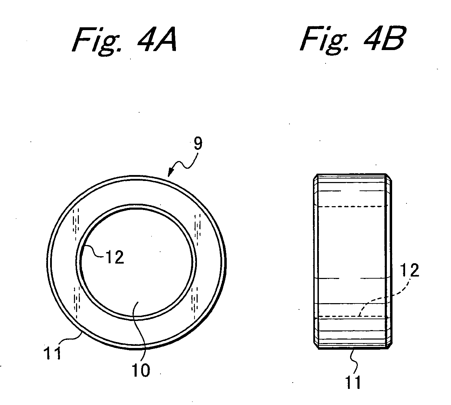

Figs. 3A, 3B and 3C show a condition that various electronic components are mounted on the base board 1 of Figs. 1A and 1B, wherein ferrite cores 9, 9, 9 are mounted on the core mounting sections 2, 2, 3 respectively The ferrite core 9 is in a ring shape as shown in Figs. 4A and 4B, and has a large hole 10 penetratingly formed in the center, and furthermore has an outer circumferential face 11 and an inner circumferential face 12 being smooth. The ring-like ferrite core 9 is mounted while being nipped between the outer-circumferential-side holding members 4, 4 and the inner-circumferential-side holding member 5 as shown in Figs. 2A, 2B and 2C.

Cables 13, 13, 13 are wound on the ferrite cores 9, 9, 9 mounted on the core mounting sections 2, 2, 3. That is, when a plug 14a provided outside the baseboard 1 is connected to a plug 14b provided on the baseboard 1 by the cable 13, the cable 13 is wound on the ferrite core 9 in the middle of them. As a result, various kinds of noise flowing through the cable 13 are removed by the ferrite core 9. While the cable 13 is wound on the ferrite core 9 in Fig. 3A, it may be wired to be guided through the center hole 10.

A printed circuit board is mounted on the base board 1 shown in Figs. 1A and 1B, and a cable 13 for connecting the printed circuit board to another printed circuit board, or a cable 13 for connecting the printed circuit board to an electronic component (such as a speaker) in a device is disposed. Noise generated from the respective cables 13, 13, 13 is removed by the ferrite cores 9, 9, 9 mounted on the core mounting sections 2, 3 provided on the base board 1. In addition, the cables 13, 13, 13 can be fixed to predetermined positions by being nipped in the core mounting sections 2, 3. That is, the core mounting sections 2, 3 integrally molded with the base board 1 can be used for mounting the ferrite cores 9, 9, 9, in addition, for fixing the cables 13, 13, 13.

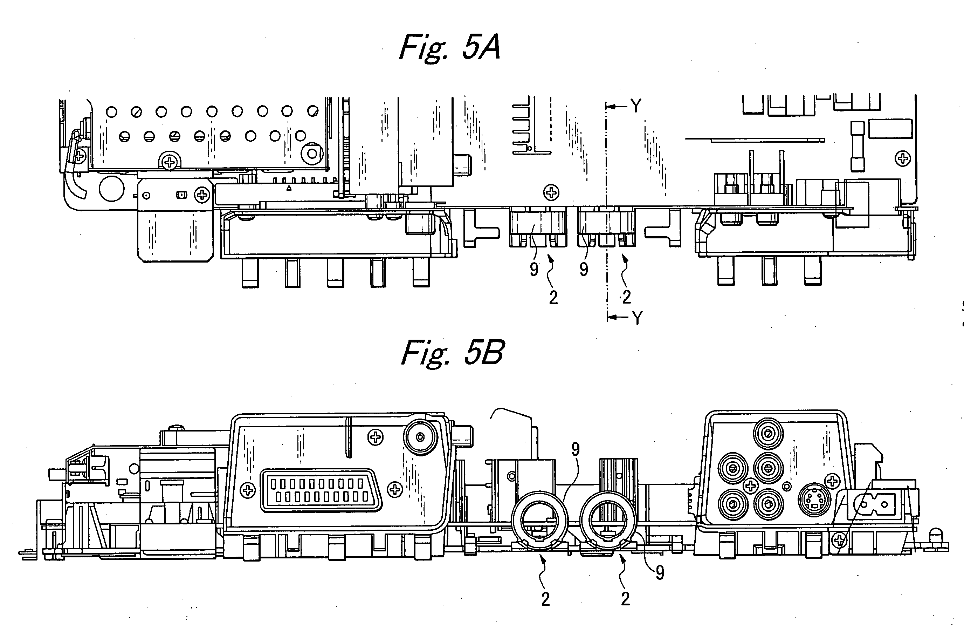

Figs. 5A and 5B show a condition that the ferrite core 9 is mounted on the core mounting section 2, in which the ferrite core 9 is nipped by the outer-circumferential-side holding members 4, 4 and the inner-circumferential-side holding member 5. That is, the outer circumferential face 11 of the ring-like ferrite core 9 is set on the slopes 4a, 4a formed on the outer-circumferential-side holding members 4, 4, and the inner-circumferenfial-side holding member 5 is inserted into the hole 10 and presses the inner circumferential face 12. Therefore, the ferrite core 9 is stably mounted by three-point support.

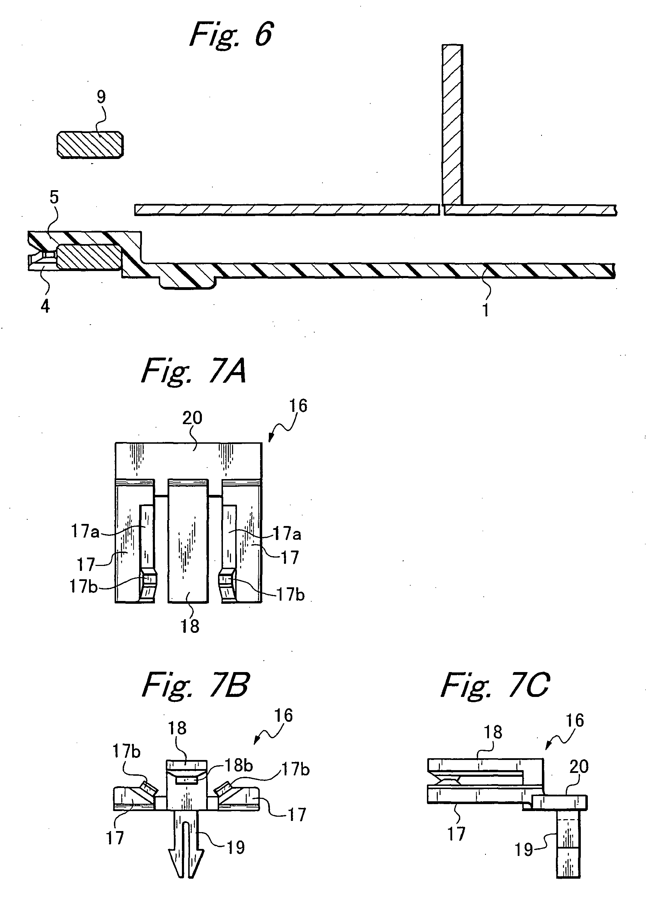

When the ferrite core 9 is mounted on the core mounting sections 2, 2, 3, a tip of the inner-circumferential-side holding member 5 is raised and the ferrite core 9 is inserted between the inner-circumferential-side holding member 5 and the outer-circumferential-side holding members 4, 4. Once the ferrite core 9 is nipped, it is latched on the projections 4b, 4b protrusively provided on the tips and thus does not fall off. As shown in Fig. 6, an embodiment of the invention is structured such that only a lower portion of the ferrite core 9 is nipped to be mounted, and most of the ferrite core 9 is not restrained.

Therefore, even if the ferrite core 9 is inserted with the cable 13, or wound with the cable 13, the cable 13 is not nipped between the outer-circumferential-side holding members 4, 4 and the inner-circumferential-side holding member 5. In addition, since the outer-circumferential-side holding members 4, 4 and the inner-circumferential-side holding member 5 configured by an elastic material nip the ferrite core 9 while applying elastic force thereto, the ferrite core can be stably held.

Figs. 7A, 7B and 7C show a mounting section of a ferrite core according to an another embodiment of the invention, which is common in a basic structure as a core mounting section, but different from the above embodiment in that a core mounting section 16 is configured by a different member from that of the base board 1. That is, the core mounting section 16 has outer-circumferential-side holding members 17, 17 and an inner-circumferential-side holding member 18 being integrally molded. The outer-circumferential-side holding members 17, 17 and the inner-circumferential-side holding member 18 are connected integrally at a base side through a base 20, and a leg 19 extending downward is integrally formed with the base 20. Slopes 17a, 17a inclined at a predetermined angle are formed on the outer-circumferential-side holding members 17, 17, and projections 17b, 17b are protrusively formed in the fronts of the slopes 17a, 17a.

The inner-circumferential-side holding member 18 extends parallel to the outer-circumferential-side holding members 17, 17, and has a projection 18b, which projects downward, at a tip. When the ferrite core 9 is mounted, a tip of the inner-circumferential-side holding member 18 is raised, thereby the member 18 is deformed in a deflective manner, and thus an entrance side is opened to nip the ferrite core 9. Again in the case of the core mounting section 16, the outer circumferential face 11 of the ferrite core 9 is set on the inclined slopes 17a, 17a in a contact manner, and the inner circumferential face 12 is pressed by the inner-circumferential-side holding member 18 inserted into the hole 10.

Once the ferrite core 9 is nipped by the outer-circumferential-side holding members 17, 17 and the inner-circumferential-side holding member 18, the ferrite core 9 does not fall off by the projections 17b, 17b and the projection 18b. The core mounting section 16 according to the embodiment can be mounted with the leg 19 being fitted in the hole provided in the baseboard 1.

## Claims

1. A mounting structure of a ring-like ferrite core (9) to be mounted on a device body for removing noise flowing through a cable, **characterized in that**:
the structure includes an outer-circumferential-side holding member (4, 17) for supporting an outer circumferential face (11) of the ferrite core (9), and
an inner-circumferential-side holding member (5, 18) for supporting an inner circumferential face (12),
wherein at least one of the outer-circumferential-side holding member (4, 17) and the inner-circumferential-side holding member (5, 18) is formed to extend in an axial direction of the ferrite core so that it can deflect by elastic deformation, thereby the outer-circumferential-side holding member and the inner-circumferential-side holding member nip the ferrite core while applying elastic force thereto.

2. The mounting structure of the ferrite core according to claim 1, wherein the outer-circumferential-side holding member (4, 17) includes a pair of members disposed parallel to each other with a predetermined interval, and the inner-circumferential-side holding member (5,18) is disposed in the middle of the two outer-circumferential-side holding members.

3. The mounting structure of the ferrite core according to claim 1 or 2, wherein a projection (6, 7 or 21, 22) to be latched on an end face of the ferrite core (9) is formed on a tip of at least one of the outer-circumferential-side holding member (4, 17) and the inner-circumferential-side holding member (5, 18).

4. The mounting structure of the ferrite core according to claim 1, 2 or 3, wherein the outer-circumferential-side holding member (4, 17) and the inner-circumferential-side holding member (5, 18) are formed integrally with a base board (1) of a device body on which an electronic component such as a printed circuit board is to be mounted.

5. The mounting structure of the ferrite core according to claim 1, 2 or 3, wherein a base (20) for integrally connecting the outer-circumferential-side holding member (4, 17) to the inner-circumferential-side holding member (5, 18) is formed, and the base has a leg (19) to be freely removable or mountable with respect to a base board of a device body.
